# EUROPEAN PATENT SPECIFICATION

(11) **EP 0 532 244 B1**
(45) Date of publication and mention of the grant of the patent: **18.12.1996**
(21) Application number: 92308068.3
(22) Date of filing: 04.09.1992
(51) Int. Cl.: H01L 23/433, H01L 23/48

(54) **Semiconductor device**
Halbleiteranordnung
Dispositif semi-conducteur

(30) Priority: 13.09.1991 JP 233503/91
(43) Date of publication of application: 17.03.1993
(73) Proprietor: FUJI ELECTRIC CO. LTD., Kawasaki 210 (JP)
(72) Inventor: Takahashi, Yoshikazu, Matsumoto-city 390 (JP)
(74) Representative: Carmichael, David Andrew Halliday

(56) References cited:
- EP-A- 0 006 445
- FR-A- 2 555 812
- US-A- 3 401 317
- US-A- 3 993 123
- PATENT ABSTRACTS OF JAPAN vol. 13, no. 23 (E-705)(3371) 19 January 1989 & JP-A-63 226 952

## Description

The present invention relates to a semiconductor device such as an insulated gate-type bipolar transistor (IGBT), for example, in which many semiconductor devices are accommodated in one container, the electrodes thereof being connected to a terminal drawn from the container.

In US Patent 3,401,317, a device is described wherein a fuse element is incorporated by soft-soldering an end of a tension spring to one of a pair of conductor plates, brazing the other end of the spring to the other conductor plate of the pair, and holding the conductor plates apart to impose tensile stress on the spring. When the temperature of the soft solder joint rises, the joint parts and the spring retracts, breaking the electrical connection between the conductor plates.

French Patent 2,555,812 describes an arrangement for mounting a plurality of IC chips on a substrate, each chip being in thermal contact with a heat dissipating block which is itself in thermal contact with a heat-conductive cap covering the IC chip array, an external heat dissipator being attached to the outside of the cap.

In a module in which many IGBT chips, for example, are accommodated in one container and connected in parallel, the collector electrodes located beneath the chips may be connected to each other by fixing the chips on an electrically conductive substrate, but the emitter electrodes located above the chips must be connected individually to a conductor that is connected to a terminal extending out from the container. Such a connection has previously been made conventionally by aluminium bonding wires, with many wires being bonded to one chip depending on the current-carrying capacity.

The industrial and vehicle applications have come to demand in recent years that IGBT modules have larger capacities than conventional modules, and that they be compact and have a low inductance. However, the conventional module construction, in which connection from the emitter side has depended on aluminium wire bonding, allows heat to dissipate from the collector side, although not from the emitter side. As a result, the larger the capacity of the module, the greater the number of IGBT chips that must be integrated in the module, making a size increase in the module itself unavoidable. In addition, the number of aluminium wires bonded in the module must necessarily increase from several dozen to several hundred wires, making the inductance of each wire increase, which, in turn, makes it difficult to use the module in applications with high frequencies.

The present invention is intended to provide a semiconductor device which is capable of suppressing the number of semiconductor elements by improving the heat dissipation from not only the IGBT modules, but also from the top of semiconductor elements, even when increasing their capacities, and ensuring that it is still capable of not increasing the internal inductance for connection to the top electrodes.

In order to achieve the above objectives, a semiconductor device according to the present invention has a construction wherein a plurality of semiconductor elements are accommodated in one container, electrodes on one side of each element being made to contact with contacting bodies made of a metal whose thermal expansion coefficient approximates to that of the material of the semiconductor elements, and the electrodes are pressurised by electrically conductive springs present between the contacting body and one terminal body, which has one side exposed to the outside.

Alternatively, a plurality of semiconductor elements may be accommodated in one container, with electrodes on one side of each element being made to contact with contacting bodies made of a metal whose thermal expansion coefficient approximates to that of the material of the semiconductor elements and is coupled with a heat-conductive pressurising body via electrically conductive plates, said electrodes being pressurised by heat-conductive springs present between the pressurising body and one terminal body, which has one side exposed to the outside, and said electrically conductive plates being common to each element and connected electrically to said terminal body. Advantageously, supporting plates made of a metal whose thermal expansion coefficient approximates to that of the material of the semiconductor elements are interposed between the electrodes on the other side of each semiconductor element, and the other terminal body, which has one side exposed to the outside. It is also advantageous for the space within the container to be filled with a heat-conductive material such as a gel.

Due to the contacting bodies and the electrically conductive, and therefore, heat-conductive springs interposed between the electrodes on one side of each semiconductor element and a partially exposed terminal body, and to the contacting bodies made of metal and pressurising bodies coupled with the contacting bodies via interposed electrically conductive plates, the heat generated at the semiconductor elements is transferred to the terminal body through the contacting bodies and the spring or through the contacting bodies, the pressurising bodies, and the spring. Therefore, such heat is dissipated externally from the exposed face of this terminal body, thereby enabling an increase in the current-carrying capacity of each semiconductor element. Moreover, because it is possible to lead the current directly to the terminal body through the contacting bodies made of metal or to the terminal body from the contacting bodies through common electrically conductive plates, a connection between each element and the electrodes by using wire bonding is no longer necessary, which, in turn, leads to a decrease in the inductance. Furthermore, heat dissipation is improved by filling with gel material that has good heat conductivity.

Embodiments of the present invention will now be explained with reference to the drawings, in which:
Figure 1 is a partial cross section of an IGBT module according to one embodiment of the present invention;
Figure 2 is a plan view of an IGBT chip;
Figure 3 is a partial cross section of an IGBT module according to a different embodiment of the present invention;
Figure 4 is a perspective outline drawing of an IGBT module according to an embodiment of the present invention; and
Figure 5 is a side view of an inverter stack using IGBT modules according to an embodiment of the present invention.

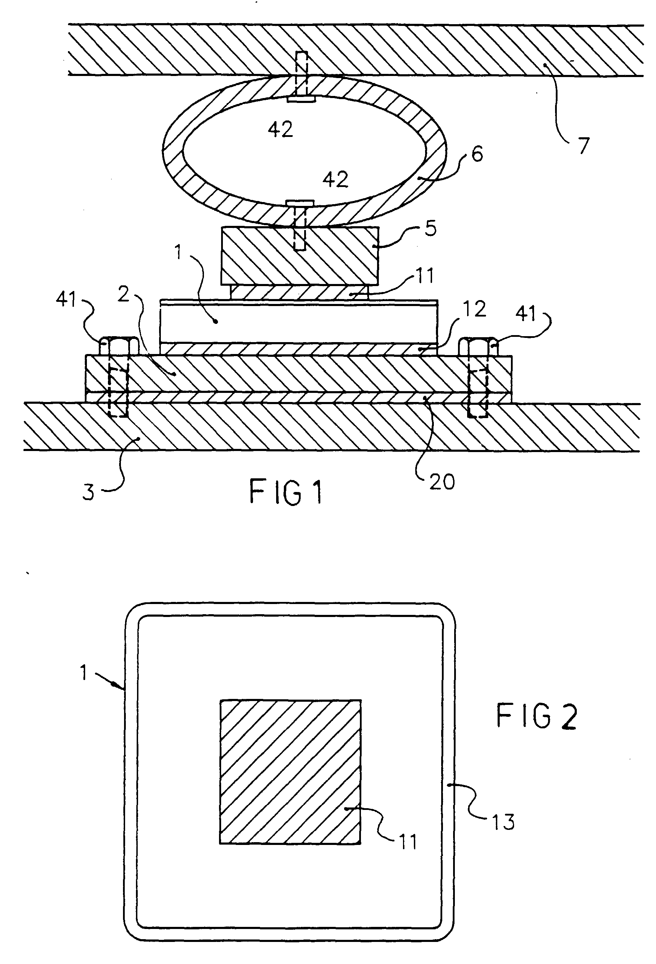

The embodiment shown in Figure 1 has a construction in which the members that play a role in heat dissipation also serve as current paths. On the top surface of the IGBT 1 which is made of silicon and shown in the Figure, the emitter power-collecting electrode 11 is disposed so that it covers the gate structure as shown in the plan view of Figure 2, while the collector electrode 12 is disposed beneath the IGBT chip. The edge 13 is formed around the circumference of the chip 1 to ensure the withstand voltage. The collector electrode 12 is brazed or fused to a supporting plate 2 made of molybdenum (Mo) and having nearly the same thermal expansion coefficient as a plate made of silicon. This Mo plate 2 is fitted to a collector terminal plate 3 made of copper, which has one face exposed to the outside, via the intermediate plate 20 using screws 41. However, the plate may be brazed or soldered rather than screwed down. The Mo contacting plate 5 is in contact with the surface of the emitter power-collecting electrode 11. The ring-shaped spring 6 is disposed between this Mo contacting plate 5 and the emitter terminal plate 7 which is exposed to the outside. Said spring is made of steel having a thickness of about 2 mm, and exhibiting good electrical and heat conductivity. Said spring is screwed down on to the Mo plate 5 and the terminal plate 7 with screws 42. Therefore, the current and heat paths consisting of the emitter power-collecting electrode 11, the Mo plate 5 and the spring 6 are installed between the chip 1 and the emitter terminal plate 7. In this construction a pressurised contact is created between the Mo contacting plate 5 and the emitter power-collecting electrode 11, and the Mo plate 5 may be fused onto the electrode 11 which is made of aluminium (Al), for example.

The spring 6 serves also in this case to elevate the reliability of connecting the chip 1 to the Mo contacting plate 5 or the Mo supporting plate 2. Although not shown, the gate electrode is connected with a gate terminal, which is exposed to the outside via Al wire bonding.

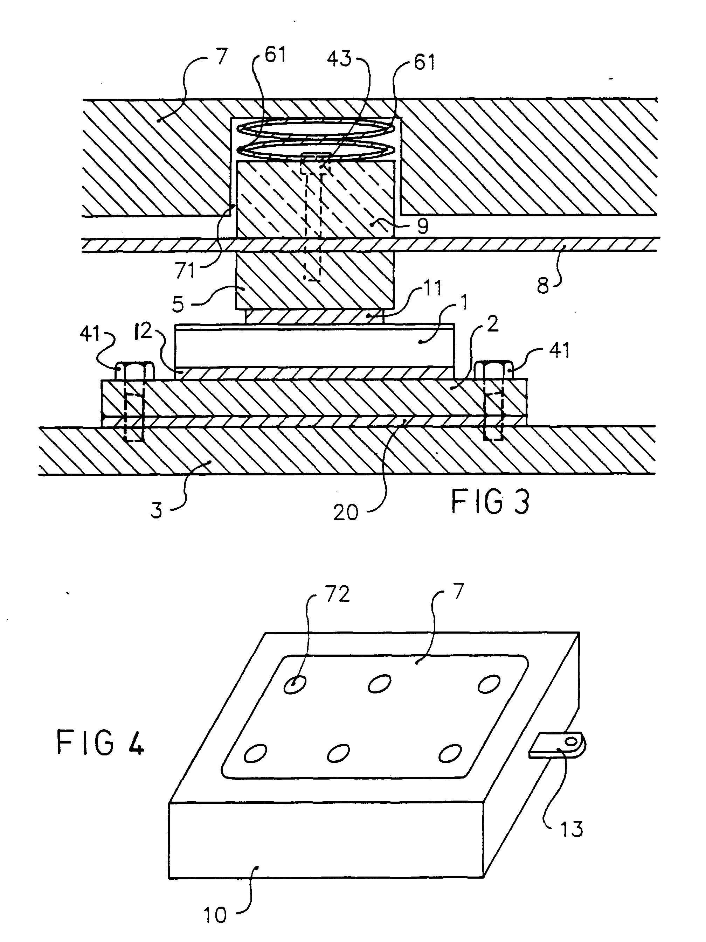

Figure 3 shows a construction in which the members playing the role of dissipating the heat and the members that work as the current-flowing path are independent of each other, the parts common with those in Figure 1 being given the same numerals. In this case, the Al203 (alumina) plate 9 which is an insulator that is high in heat conductivity is fixed on to the Mo contacting plate 5 by the screw 43, with a copper plate that has a thickness of about 1 mm held between the alumina plate and the Mo contacting plate, and the spring 61, which is made of silver (Ag) and has good heat conductivity, is inserted in two steps between the Al203 plate 9 and the emitter terminal plate 7. The Cu plate 8 is bent and screwed down or brazed onto the terminal plate 7 at points not shown in the Figure. Thus, a heat-dissipating path consisting of the emitter power-collecting electrode 11, the Mo contacting plate 5, the Cu plate 8, the Al203 plate 9, and the spring 61, and a current-flowing path consisting of the Mo contacting plate 5 and the Cu plate 8 are constructed between the chip 1 and the emitter terminal plate 7. Meanwhile, part of the Al203 plate and the spring 61 are housed in the recessed part 71 of the terminal plate 7 in order to keep the container height as low as possible, and part of the heat propagates from the side of the Al203 plate 9 to the inner face of the recessed part 71 through the clearance.

As shown in Figures 1 and 3, it is possible to make an IGBT module in such a way that its volume will be reduced to about half of that of conventional modules to allow the module to be cooled from both sides. Furthermore, the heat dissipation toward the emitter terminal 7 side is improved by the introduction of a gel with a high heat conductivity as is, for example, a gel resin containing alumina.

Figure 4 shows the appearance of the IGBT module as illustrated in Figures 1 and 3, wherein the emitter terminal plate 7 is exposed on the top of the container surrounded by insulating side walls 10, while the gate terminal 13 protrudes from one side. The emitter terminal 7 is drilled with cooling-body fitting holes 72.

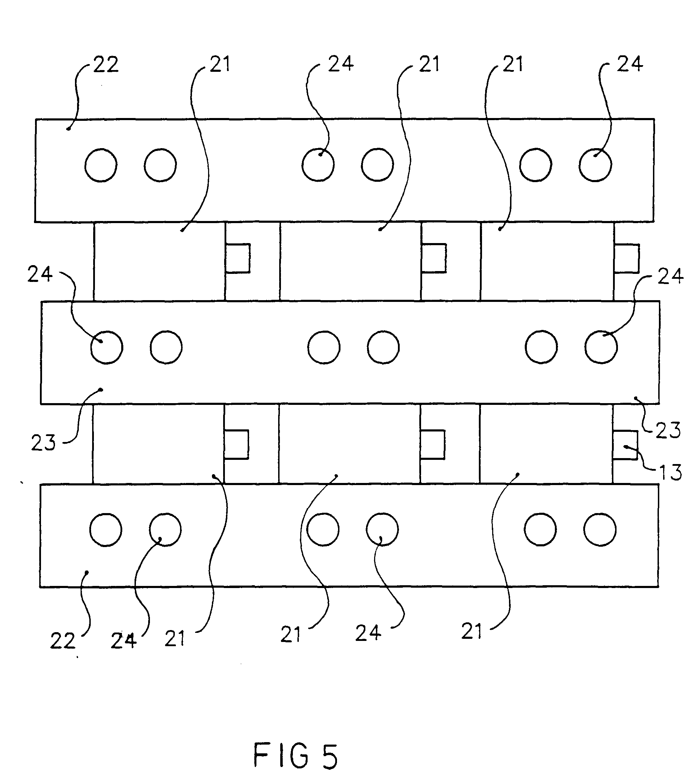

Figure 5 illustrates the construction of the above-mentioned IGBT module, which has been constructed as a three-phase inverter stack. Six IGBT modules are sandwiched between two cooling bodies 22 in three parts, each consisting of two modules, via three intermediate cooling bodies 23. The cooling bodies 22 and 23 are drilled with holes 24 to insert heat pipes or flow cooling water. Since the low-inductance modules are assembled so that the cooling bodies that serve also as electrical connectors are in contact with the terminal plates on both sides of the module as described above, the inverter stack also has a low inductance on the whole, and is compact. Although the above embodiments were explained with reference to IGBT modules, it goes without saying that the embodiments can be applied also to a module that accommodate many other semiconductor elements.

By the use of the present invention, by pressing the contacting bodies onto the electrodes of each semiconductor element using a spring that makes contact with the inner face of a terminal plate in which one side of the semiconductor device containing many semiconductor elements in one container is exposed outside the container, and at the same time, by using the spring as a part of the paths for heat and current, it is possible to dissipate heat from both sides of a substrate, thereby making it possible to produce a module with a small volume to bear a large current carrying capacity, and differing from conventional semiconductor devices in which electrical connections are executed by wire bonding. In addition, since no wires are used for connections inside the container, the internal inductance is decreased, thereby making it possible to use the module in high frequency regions.

## Claims

1. A semiconductor device in which a plurality of semiconductor elements (1) are accommodated in one container, electrodes (11) on one side of each element being made to contact with contacting bodies (5) made of a metal whose thermal expansion coefficient approximates to that of the material of the semiconductor elements (1), and said electrodes (11) being pressurised by electrically conductive springs (6) present between the contacting body (5) and a terminal body (7) which has one side exposed to the outside.

2. A semiconductor device as claimed in Claim 1, in which the contacting bodies (5) are coupled with a heat conductive pressurising body (9) via electrically conductive plates (8), said springs being heat conductive springs (61) present between the pressurising body (9) and the terminal body (7) which has one side exposed to the outside, said electrically conductive plates (8) being common to each element and connected electrically to the terminal body (7).

3. A semiconductor device as claimed in Claim 1 or 2, in which supporting plates (2) are provided which are made of a metal whose thermal expansion coefficient approximates to that of the material of the semiconductor elements and said plates (2) are interposed between electrodes (12) on the other side of each semiconductor element (1) and another respective terminal body (3), one side of which is exposed to the outside.

4. A semiconductor device as claimed in Claim 1 or 2, in which space in the container is filled with a heat conductive gel material.

## Patentansprüche

1. Halbleiteranordnung, in der eine Mehrzahl von Halbleiterelementen (1) in einem Behälter untergebracht sind, Elektroden (11) an einer Seite jedes Elements hergestellt werden, um mit kontaktherstellenden Körpern (5) Verbindung aufzunehmen, die aus einem Metall bestehen, dessen thermischer Ausdehnungskoeffizient sich dem des Materials der Halbleiterelemente (1) nähert, und die Elektroden (11) durch elektrisch leitende Federn (6) unter Druck gesetzt werden, die zwischen den kontaktherstellenden Körper (5) und einem Anschluß-Körper (7) angeordnet sind, dessen eine Seite nach außen offenliegt.

2. Halbleiteranordnung nach Anspruch 1, in der die kontaktherstellenden Körper (5) mit einem wärmeleitenden, druckausübenden Körper (9) über elektrisch leitende Platten (8) gekoppelt sind, wobei die Federn wärmeleitende Federn (61) sind, die zwischen dem druckausübenden Körper (9) und dem Anschluß-Körper (7) angeordnet sind, dessen eine Seite nach außen offenliegt, und die elektrisch leitende Platten (8) jedem Element gemeinsam sind und elektrisch mit dem Anschluß-Körper (7) verbunden sind.

3. Halbleiteranordnung nach Anspruch 1 oder 2, in der Auflageplatten (2) vorgesehen sind, die aus einem Metall bestehen, dessen thermischer Ausdehnungskoeffizient sich dem des Materials der Halbleiterelemente nähert und die Platten (2) zwischen die Elektroden (12) auf der anderen Seite jedes Halbleiterelements (1) und einem anderen jeweiligen Anschluß-Körper (3) eingeschoben sind, dessen eine Seite nach außen offenliegt.

4. Halbleiteranordnung nach Anspruch 1 oder 2, in der der Raum innerhalb des Behälters mit einem wärmeleitenden Gel-Material gefüllt wird.

## Revendications

1. Dispositif à semiconducteur, dans lequel plusieurs éléments semiconducteurs (1) sont logés dans un même boîtier, des électrodes (11) situées sur un même côté de chaque élément étant réalisées de façon à venir en contact avec des corps de mise en contact (5) faits d'un métal dont le coefficient de dilatation thermique est proche de celui du matériau des éléments semiconducteurs (1), et lesdites électrodes (11) étant placées sous la pression de ressorts électriquement conducteurs (6) présents entre le corps de mise en contact (5) et un corps formant borne (7), qui présente une face à découvert sur l'extérieur.

2. Dispositif à semiconducteur tel que défini dans la revendication 1, dans lequel les corps de mise en contact (5) sont couplés à un corps de pression (9) conducteur de la chaleur, par l'intermédiaire de plaques électriquement conductrices (8), lesdits ressorts étant des ressorts conducteurs de la chaleur (61) placés entre le corps de pression (9) et le corps formant borne (7) qui présente une face à découvert sur l'extérieur, lesdites plaques électriquement conductrices (8) étant communes à tous les éléments et étant raccordées électriquement au corps formant borne (7).

3. Dispositif à semiconducteur tel que défini dans la revendication 1 ou 2, dans lequel sont prévues des plaques de support (2) qui sont faites d'un métal dont le coefficient de dilatation thermique est proche de celui du matériau des éléments semiconducteurs, et lesdites plaques (2) sont interposées entre des électrodes (12), situées sur l'autre côté de chaque élément semiconducteur (1), et un autre corps formant borne (3) respectif, dont une face est à découvert sur l'extérieur.

4. Dispositif à semiconducteur tel que défini dans la revendication 1 ou 2, dans lequel l'espace intérieur du boîtier est rempli d'un matériau constitué par un gel conducteur de la chaleur.
